# FASCICULE DE BREVET EUROPEEN

(11) **EP 0 507 676 B1**
(45) Date de publication et mention de la délivrance du brevet: **15.05.1996**
(21) Numéro de dépôt: 92400909.5
(22) Date de dépôt: 01.04.1992
(51) Int. Cl.: H05K 9/00

(54) **Matériau pour écran semi-conducteur**
Material für Halbleiter-Abschirmung
Material for semiconductor screen

(30) Priorité: 02.04.1991 FR 9103955; 28.01.1992 FR 9200870
(43) Date de publication de la demande: 07.10.1992
(73) Titulaire: ALCATEL CABLE, F-92111 Clichy Cédex (FR); SOLVAY (Société Anonyme), B-1050 Bruxelles (BE)
(72) Inventeur: Aladenize, Bernard, F-91360 Epinay Sur Orge (FR); Galaj, Stanislas, F-94110 Arcueil (FR); Le Mehaute, Alain, F-91190 Gif Sur Yvette (FR); Hannecart, Etienne, B-3080 Tervuren (BE); Franquinet, Claude, Institut des Arts et Metiers, B-1140 Bruxelles (BE)
(74) Mandataire: Laroche, Danièle

(56) Documents cités:
- EP-A- 0 399 299
- WO-A-90/09027
- DE-A- 3 305 401
- FR-A- 2 596 403

## Description

La présente invention a pour objet un matériau pour écran semi-conducteur ainsi que son application à la fabrication de câbles et au blindage électromagnétique d'appareils électriques et électroniques.

Selon une configuration classique, les câbles sont constitués d'un toron métallique recouvert d'un feuillard de cuivre et entouré d'une gaine d'isolant, par exemple du polyéthylène. Selon une autre configuration classique, à titre d'exemple, les torons métalliques sont directement entourés d'une gaine d'isolant. Les câbles sont utilisés à très grande échelle dans divers domaines, comme les télécommunications, le transport de l'énergie et autres. Ces câbles véhiculent de l'énergie électromagnétique en continu ou sous basse, haute et très haute fréquence avec ou sans répéteur. Ils sont donc soumis lors de leur utilisation à des champs électriques et à des charges d'espace, se caractérisant par des courants de dépolarisation à grande constante de temps, qui font apparaître, à la longue, pour certaines tensions de polarisation, des anomalies de comportement.

Dans ces configurations ainsi que dans les autres configurations classiques où la gaine d'isolant est placée par exemple sur le corps soit central, soit externe du câble, le champ maximum est situé à l'interface conducteur-isolant. Une valeur typique de ce champ est de l'ordre de quelques kV/mm à une dizaine de kV/mm. Ainsi, cette interface est particulièrement sollicitée. Il s'ajoute à la localisation du champ maximum des problèmes de régularité du conducteur. En effet, si celui-ci présente des irrégularités, celles-ci engendrent des concentrations de champ électrique, ce qui réduit d'autant l'aptitude du câble à resister aux gradients de tension. Il convient donc d'accroître l'épaisseur de l'isolation de façon à garantir qu'aucun claquage ne se produira même si des protubérances sont présentes. Une telle solution est économiquement désavantageuse.
Le problème de la taille de l'isolation est particulièrement critique aux niveaux des jonctions, des dérivations et des extrémités des câbles haute tension.

Les problèmes rencontrés lors de l'emploi et de la réalisation des câbles se posent aussi sensiblement de la même manière dans les dispositifs de stockage de l'énergie électrique et notamment dans les condensateurs. On y est confronté également lors de l'emploi d'appareils électriques ou électroniques, dans lesquels un isolant protège une zone où se trouve un appareillage sensible d'une source d'un champ électrique. Cette source peut être, par exemple, un générateur de courant, des broches ou des câbles électriques, des antennes émettrices et autres. L'appareillage sensible peut être, par exemple, un appareil de mesure, un récepteur du type récepteur F.M., ou des circuits imprimés du type de ceux contenus dans un microordinateur. Dans tous ces types d'appareils, il est nécessaire d'introduire un isolant, parfois situé au contact direct à la fois de l'appareillage et de la source du champ.

Afin de pallier ces problèmes, il a été proposé d'interposer, entre le conducteur et l'isolant, ou entre la source et l'isolant, un écran semi-conducteur. Les écrans semi-conducteurs employés jusqu'à présent sont formés de noir de carbone dispersé dans une matrice extrudée, calandrée ou moulée, en général formée de EVA (ethylène-acétate de vinyle) ou de EBA (éthylène-butylacrylate). L'inconvénient majeur de ces écrans semi-conducteurs est que leur conductivité reste constante en fonction du champ, et qu'ils ne permettent pas de réduire le volume de l'isolation de manière suffisante.

Il a été proposé par ailleurs, par exemple dans le document Wo 90/09027 d'utiliser pour les écrans semi-conducteurs un matériau composite intrinsèquement conducteur constitué d'une matrice polymère, par exemple en polyoléfine, polychlorure de vinyle, polystyrène, dans laquelle est incorporé un polythiophène substitué.
La conductivité d'un tel matériau est fonction de la quantité des dopants qu'il contient ; mais la présence même de ces dopants est un inconvénient majeur pour la stabilité physico-chimique de l'écran sous haute tension, en présence d'un champ électrique élevé.

La présente invention a pour but de mettre en oeuvre un matériau pour écran semi-conducteur dont la conductivité soit croissante en fonction du champ appliqué, et qui présente en même temps une bonne stabilité physico-chimique même si le champ est très intense.

La présente invention a pour objet un matériau pour écran semi-conducteur thermoplastique ou thermodurcissable et dans laquelle est incorporé au moins un second polymère conjugué, caractérisé par le fait que ledit second polymère conjugué est non dopé ou dédopé, non intrinsèquement conducteur, avec une conductivité inférieure à 10⁻⁴ S/m mais susceptible de croître sous l'effet d'un champ électrique, ce second polymère se trouvant dans ladite matrice dans une proportion de 5 % à 70 % en poids, ledit matériau ayant une conductivité inférieure à 10⁻⁸ S/m, mais susceptible de croître sous l'effet dudit champ électrique, ledit polymère thermoplastique étant choisi parmi les résines acryliques, styréniques, vinyliques, cellulosiques, les polyoléfines, les polymères fluorés, les polyéthers, les polyimides, les polycarbonates, les polyuréthannes, leurs mélanges et leurs copolymères, ledit polymère thermodurcissable étant choisi parmi les polyesters, les résines époxydes et les résines phénoliques.

De préférence ladite conductivité dudit second polymère conjugué est de l'ordre de 10⁻⁷ S/m à 10⁻⁸ S/m et ladite conductivité dudit matériau est de l'ordre de 10⁻⁹ S/m à 10⁻¹⁰ S/m.

Ladite matrice polymérique peut contenir en outre une charge conductrice du type noir de carbone dans une proportion inférieure à 30 %.

Selon des modes de réalisation particuliers, ledit polymère thermoplastique est choisi parmi le polypropylène (PP), le polyéthylène (PE), le copolymère d'éthylène et d'acétate de vinyle (EVA), l'éthylène-propylène-diène-monomère (EPDM), le polyvinylidène fluoré (PVDF) l'éthylène-butylacrylate (EBA) et leurs mélanges.

Ledit second polymère conjugué peut être choisi dans le groupe comprenant la polyaniline, le polythiophène, le polypyrrole, le polyacétylène, le polyparaphénylène, les polyalkylthiophènes, leurs dérivés et leurs mélanges.

Il est très important que ledit polymère conjugué soit non-dopé, c'est-à-dire qu'il ne contienne pas de groupements ioniques
. soit fixés sur la molécule (par exemple des groupements sulfoniques)
. soit libres (par exemples, des acides, des bases, des sels métalliques)
Si la présence de ces groupements résultent de la synthèse du polymère conjugué, il convient de le dédoper.

S'il ne contient aucune charge conductrice du type noir de carbone, le matériau selon l'invention est isolant à bas champ et sa conductivité croît en fonction du champ. S'il contient une certaine quantité de charge conductrice supplémentaire, le matériau selon l'invention est faiblement conducteur à bas champ grâce à cette charge. Sous un champ élevé la conductivité du matériau selon l'invention se trouve amplifiée.

Qu'il contienne ou non ladite charge supplémentaire, le matériau selon l'invention présente une grande stabilité physico chimique sous champ élevé.

Les propriétés du matériau selon l'invention utilisé comme écran semi-conducteur permettent de stabiliser le champ à l'interface isolant-conducteur et de limiter le champ dans l'isolant.

On choisira par ailleurs le premier et le second polymères dans les groupes définis plus haut en fonction de leurs propriétés spécifiques et des avantages particuliers qu'ils peuvent apporter.
Ainsi, à titre d'exemple si la matrice polymérique est à base d'un polymère fluoré, ce dernier forme des complexes à "transfert de charges" avec le second polymère. Si la matrice polymérique est à base d'un polycarbonate, ce dernier donne à un écran en matériau selon l'invention un excellent aspect extérieur.

Selon un premier mode de réalisation préférentiel, le matériau selon l'invention est formé d'une matrice polymérique en polyéthylène dans laquelle est incorporé du polythiophène dédopé; la proportion de polythiophène dédopé est avantageusement de l'ordre de 60% en poids.

Selon un autre mode de réalisation préférentiel le matériau selon l'invention est formé d'une matrice polymérique en polyéthylène dans laquelle est incorporé de la polyaniline à raison de 25% à 35% en poids. En variante on incorpore dans la matrice en polyéthylène 26% à 34% de polyaniline et 3% à 8% de noir de carbone. En variante, le polyéthylène (PE) de la matrice polymérique est remplacé par du polypropylène (PP), du copolymère d'éthylène et d'acétate de vinyle (EVA), de l'éthylène-butylacrylate (EBA), de l'éthylène-propylène-diène-monomère (EPDM), du polyvinylidène fluoré (PVDF), seuls ou en mélange.

Un matériau semi-conducteur peut être mis en forme par les procédés classiques d'extrusion, de calandrage, ou de moulage, sans que les propriétés électriques dudit second polymère en soient altérées. Un écran semi-conducteur bien adapté à chaque application peut donc être ainsi réalisé.

Un écran semi-conducteur selon l'invention s'applique à tout appareillage électrique ou électronique. Si cet appareillage contient un isolant enrobant un conducteur ou source d'un champ, l'écran semi-conducteur selon l'invention est interposé entre lesdits isolant et conducteur ou source. Si l'appareillage contient un isolant enrobant un appareillage à protéger, l'écran semi-conducteur selon l'invention est alors situé à l'extérieur sur l'isolant.

Un écran semi-conducteur selon l'invention s'applique très avantageusement aux câbles haute tension, aux extrémités de tels câbles, et aux accessoires du genre jonctions et dérivations de câbles. La mise en oeuvre d'un tel écran permet d'accroître la tenue au claquage et de réduire la taille de l'isolement desdits accessoires.

Grâce à la mise en oeuvre de l'écran semi-conducteur selon l'invention à l'entrée d'un câble haute tension en courant continu où des fluctuations de tension peuvent apparaître, ces dernières se trouvent amorties.

Un écran semi-conducteur selon l'invention peut également être avantageusement incorporé dans des dispositifs de stockage de l'énergie électrique tels que des condensateurs. En effet, tout comme les interfaces conducteurs-isolants des câbles électriques, les interfaces électrodes-diélectriques de ces composants peuvent présenter des imperfections géométriques (telles que des protubérances) conduisant à une valeur localement plus élevée du champ électrique, d'où il résulte un risque accru de claquage.

On peut réduire avantageusement l'épaisseur du diélectrique en interposant entre les électrodes et ce diélectrique un écran semi-conducteur selon l'invention; ceci a comme effets, d'une part d'homogénéiser en permanence le champ électrique à la surface des électrodes, et d'autre part de résister à des surtensions momentanées supérieures. En effet, les condensateurs sont fréquemment utilisés pour atténuer des surtensions transitoires, résultant par exemple de la mise en service ou de la coupure d'appareillages électriques de forte puissance. Dans un tel cas, il est donc également important d'homogénéiser le champ électrique transitoire, pour éviter qu'un défaut géométrique d'une électrode ne permette à une surtension momentanée de provoquer un claquage local du diélectrique.

L'écran semi-conducteur de la présente invention peut être interposé de plusieurs manières entre les électrodes et le diélectrique.
Selon un mode de réalisation, le matériau selon l'invention est appliqué par enduction sur les électrodes. Selon un autre mode de réalisation, le matériau selon l'invention est mis sous la forme d'un film qui est ensuite pris en sandwich entre les électrodes et le diélectrique lors du montage du condensateur.
Lorsque le diélectrique est un matériau polymérique, une variante de réalisation préférée consiste en ce que la matrice polymérique du matériau selon l'invention soit de la même nature que le diélectrique.

L'écran semi-conducteur selon l'invention trouve aussi une application très intéressante dans les diélectriques pour antennes spatiales.

D'autres caractéristiques et avantages de la présente invention apparaîtront au cours de la description suivante de modes de réalisation donnés à titre illustratif mais nullement limitatif.

Dans le dessin annexé:
- la figure 1 montre l'évolution de la conductivité S/m d'un matériau pour écran de l'art antérieur et de plusieurs matériaux pour écran selon l'invention en fonction du champ électrique appliqué (KV/mm),
- la figure 2 montre la probabilité de claquage (%) d'un matériau pour écran de l'art antérieur et de plusieurs matériaux pour écran selon l'invention en fonction du champ électrique E appliqué (Kvolts).

### Exemple 1 (art antérieur)

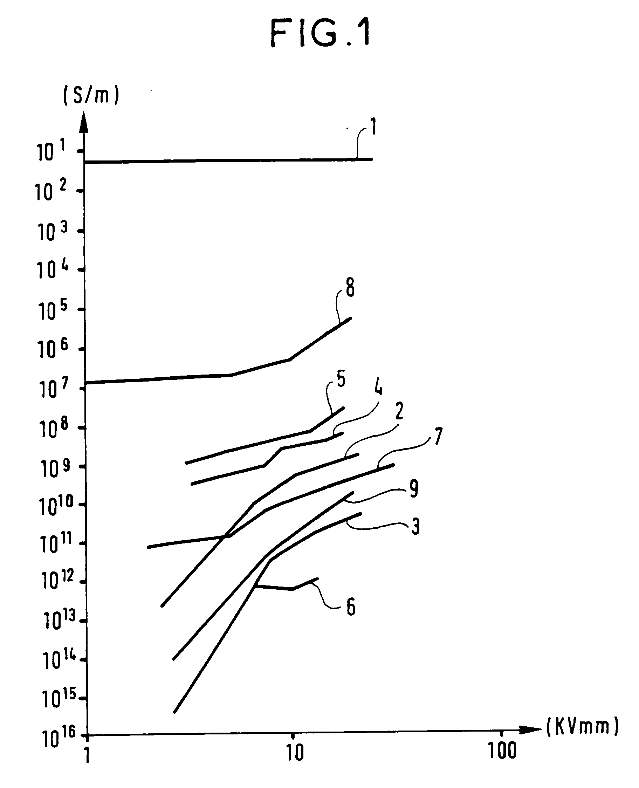

Ecran semi-conducteur en polyéthylène (PE) et noir de carbone.
25g de noir de carbone sont dispersés dans 75g de polymère (PE). Ce mélange est ensuite extrudé à une température de 130°C dans une extrudeuse classique. L'écran semi-conducteur conventionnel ainsi obtenu a les propriétés suivantes: sa constante diélectrique est de l'ordre de 150 et sa conductivité est de l'ordre de 0,05 S/m (voir courbe 1 de la figure 1). Cette conductivité est constante en fonction du champ, ce qui conduit à une réponse linéaire du courant en fonction du champ appliqué.

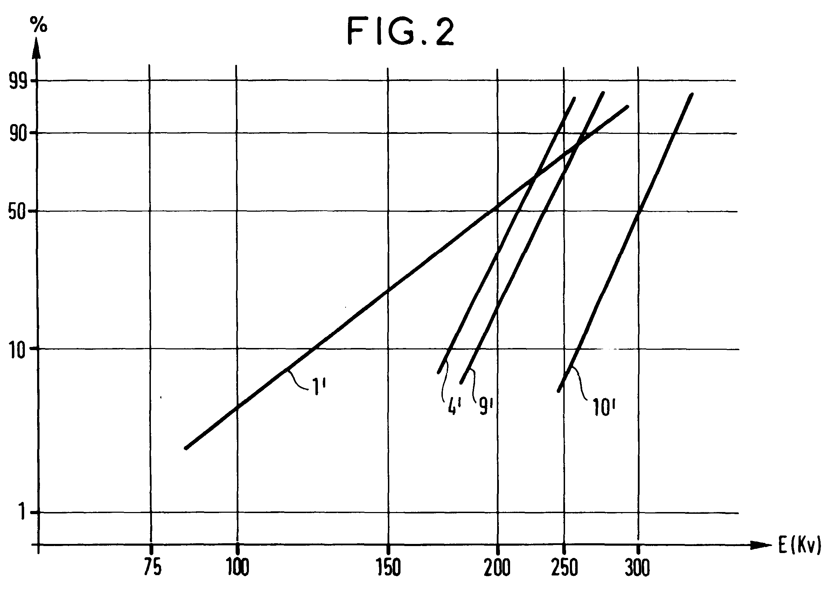

On soumet un tel écran de 0,1 m d'épaisseur à un champ électrique croissant jusqu'au claquage diélectrique. Les résultats obtenus apparaissent sur la courbe 1′ de la figure 2.

### Exemple 2

Ecran semi-conducteur polyéthylène (PE)/polythiophène dédopé (PTh).

On prépare le matériau selon l'invention de la manière suivante:
On mélange tout d'abord 60 g de poudre de polythiophène dédopé et 40 g de polyéthylène. Le polyéthylène est commercialisé par la Société SOLVAY sous la désignation "Eltex^{(TM)} A 3180".
Le polythiophène utilisé a été préparé comme décrit dans la demande de brevet EP 350.083. Ce polythiophène a été dédopé au méthanol de façon à présenter après dédopage une conductivité de 3.10⁻⁷ S/cm.

Le mélange est effectué de préférence dans la cuve d'un mélangeur "Indola" de 3 dm³ muni de deux balles en caoutchouc. On agite pendant 30 minutes.
Le mélange est ensuite malaxé pendant 60 secondes à 180°C dans un micro-malaxeur à cylindres de type "Scamia" dont les cylindres ont un diamètre 120 mm et dont la vitesse de rotation est de 30 tours par minute.
La crêpe ainsi obtenue est découpé en languettes de 30 mm de largeur, que l'on passe dans un granulateur de type "Conduct Werk CS/15/10/0101", équipé d'une grille à trous de 5 x 5 mm: on obtient des granulés d'environ 3 x 3 x 3 mm.

Les granulés sont mis en oeuvre dans une extrudeuse de type "Scamex 20", équipée d'une vis de 20 mm de diamètre D, de longueur 20D, et d'un taux de compression de 2,16. Sa tête est munie d'une filière ronde de 3 mm de diamètre.

La température de la machine est réglée de manière à obtenir 180°C dans la matière à la sortie de la filière; la vitesse de la vis est ajustée à 20 t/min., de façon à obtenir un temps de séjour moyen du mélange dans la vis de 2 à 3 minutes.

La courbe 2 de la figure 1 montre la conductivité de cet écran qui est une fonction croissante du champ électrique appliqué.

On vérifie par une série de tests que toutes les étapes du procédé qui viennent d'être décrites n'ont pas dégradé les propriétés électriques du polythiophène. Pour cela des échantillons ont été prélevés après le mélange des poudres, après le malaxage à 180°C, et après l'extrusion à 180°C. Ces échantillons ont été dissous à raison de 2 g par 100 ml, sous azote, dans du 1-2-4-trichlorobenzène, à 135°C, pendant 2 heures. Le PTh quantitativement recueilli est lavé par le même solvant et le méthanol, puis séché sous vide. On le redope par une solution de FeCl₃ 0,1 M dans de l'acétonitrile (rapport molaire FeCl₃/PTh =1) afin de prouver sa non-dégradation.

Le tableau I reprend les mesures de conductivité effectuées qui prouvent que le polymère n'a été altéré ni par le traitement thermique, ni par l'extrusion.

**TABLEAU I**

| Etapes | Conductivité après redopage (S/cm) |
|---|---|
| Mélange | 25 |
| Malaxage | 25 |
| Extrusion | 27 |

### Exemple 3 à 10

On prépare de la polyaniline non dopée en trois étapes:

### 1 - Synthèse

Dans un réacteur de 50 1, on introduit 15,5 1 d'eau distillée et, au choix, 5 l d'acide chlorhydrique à 37% ou 1,7 l d'acide sulfurique à 36%. Cette solution est refroidie à -5°C dans un bain thermostatique puis une solution filtrée de 3,75Kg de peroxosulfate d'ammonium dans 9 l d'eau est ajoutée goutte à goutte pendant 48H.

### 2 - Lavage

La suspension formée dans le réacteur (polyaniline sous sa forme polyéméraldine) est aspirée sous vide dans une enceinte filtrante. La poudre obtenue est rincée à l'eau distillée jusqu'à l'obtention d'un filtrat de pH compris entre 6,5 et 7. Les dernières traces d'acide sont éliminées par une solution diluée d'ammoniaque à 1 mole/l puis le produit est rincé jusqu'à ce que le pH du filtrat soit de 7.

Cette poudre est ensuite placée dans un "Soxhlet" et les impuretés sont extraites en phase vapeur: avec de l'eau pendant 24h puis avec de l'éthanol pendant 48h.

### 3 - Séchage

La polyaniline ainsi purifiée est placée dans une enceinte close munie d'une paroi filtrante. L'ensemble est placé dans une étuve à 60°C sous un vide primaire pendant 48H. Cette polyaniline, dont la conductivité est égale à 2 x 10⁻⁸ S/m est incorporée, comme dans l'exemple 2, à une matrice polymétrique qui peut être du polyéthylène de l'éthylène-propylène-diène-monomère (EPDM), un copolymère d'éthylène et d'acétate de vinyle (EVA), du polyvinylidène fluoré (PVDF), du polypropylène (PP) ou un mélange de polypropylène (PP) et de polyvinylidène fluoré (PVDF) dans les proportions indiquées dans le tableaux II (en grammes).

**TABLEAU II**

| Exemple n° | Polyaniline non-dopée | Matrice polymérique | Noir de carbone |
|---|---|---|---|
| 3 | 30 g | 70 g PE | 0 |
| 4 | 30 g | 70 g EVA | 0 |
| 5 | 50 g | 50 g EVA | 0 |
| 6 | 30 g | 70 g EPDM | 0 |
| 7 | 15 g | 85 g PVDF | 0 |
| 8 | 30 g | 65 g EVA | 5g |
| 9 | 30 g | 70 g PP | 0 |
| 10 | 25 g | 70g PP et 5g PVDF | 0 |

Les courbes représentatives de la conductivité en fonction du champ appliqué sont référencées respectivement 3 à 9 dans la figure 1 pour les exemples 3 à 9.

Avec les matériaux correspondant aux exemples 4, 9, 10 on réalise un écran de 0,1 mm d'épaisseur que l'on soumet, comme l'écran de l'exemple 1, à un champ électrique croissant jusqu'au claquage électrique. Les courbes 4', 9' et 10' correspondantes apparaissent dans la figure 2, et montrent clairement l'intérêt du matériau pour écran semiconducteur selon l'invention.

Bien entendu l'invention n'est pas limitée aux exemples de réalisation qui viennent d'être décrits. On pourra, sans sortir du cadre de l'invention, remplacer tout moyen par un moyen équivalent dans le cadre des revendications.

## Revendications

1. Matériau pour écran semi-conducteur comportant une matrice polymérique comprenant au moins un premier polymère isolant thermoplastique ou thermodurcissable et dans laquelle est incorporé au moins un second polymère conjugué, caractérisé par le fait que ledit second polymère conjugué est non dopé ou dédopé, non intrinsèquement conducteur, avec une conductivité inférieure à 10⁻⁴ S/m mais susceptible de croître sous l'effet d'un champ électrique, ce second polymère se trouvant dans ladite matrice dans une proportion de 5 % à 70 % en poids, ledit matériau ayant une conductivité inférieure à 10⁻⁸ S/m, mais susceptible de croître sous l'effet dudit champ électrique, ledit polymère thermoplastique étant choisi parmi les résines acryliques, styréniques, vinyliques, cellulosiques, les polyoléfines, les polymères fluorés, les polyéthers, les polyimides, les polycarbonates, les polyuréthannes, leurs mélanges et leurs copolymères, ledit polymère thermodurcissable étant choisi parmi les polyesters, les résines époxydes et les résines phénoliques.

2. Matériau pour écran semi-conducteur selon la revendication 1, caractérisé par le fait que ladite conductivité dudit second polymère conjugué non dopé ou dédopé est de l'ordre de 10⁻⁷ S/m à 10⁻⁸ S/m et ladite conductivité dudit matériau est de l'ordre de 10⁻⁹ S/m à 10⁻¹⁰ S/m.

3. Matériau pour écran semi-conducteur selon la revendication 1, caractérisé par le fait que ladite matrice polymérique contient en outre une charge conductrice du type noir de carbone dans une proportion inférieure à 30 %.

4. Matériau pour écran semi-conducteur selon la revendication 1, caractérisé par le fait que ledit polymère thermoplastique est choisi parmi le polypropylène, le polyéthylène, le copolymère d'éthylène et d'acétate de vinyle, l'éthylène-propylène-diène-monomère, le polyvinylidène fluoré, l'éthylène-butylacrylate et leurs mélanges.

5. Matériau pour écran semi-conducteur selon l'une des revendications 1 à 4, caractérisé par le fait que ledit second polymère conjugué est choisi dans le groupe comprenant la polyaniline, le polythiophène, le polypyrrole, le polyacétylène, le polyparaphénylène, les polyalkylthiophènes, leurs dérivés et leurs mélanges.

6. Matériau pour écran semi-conducteur selon la revendication 5, caractérisé par le fait que ledit second polymère conjugué est de la polyaniline et que ladite matrice polymérique comprend au moins un matériau choisi parmi le polyéthylène, le polypropylène, le copolymère d'éthylène et d'acétate de vinyle, l'éthylène-butylacrylate, l'éthylène-propylène-diène-manomère, le polyvinylidène fluoré, seuls ou en mélange.

7. Application du matériau pour écran semi-conducteur selon l'une des revendications précédentes au blindage des câbles électriques, au niveau des extrémités, des jonctions, des dérivations.

8. Application du matériau pour écran semi-conducteur selon l'une des revendications 1 à 6, à un condensateur, ledit écran étant disposé entre les électrodes et le diélectrique dudit condensateur.

9. Application du matériau pour écran semi-conducteur selon l'une des revendications 1 à 6, à un diélectrique pour antenne spatiale.

## Patentansprüche

1. Material für eine Halbleiter-Abschirmung, die eine Polymermatrix aufweist, welche mindestens ein erstes thermoplastisches oder wärmehärtbares isolierendes Polymer aufweist und der mindestens zweites konjugiertes Polymer zugesetzt ist, dadurch gekennzeichnet, daß das zweite konjugierte Polymer nicht dotiert oder ent-dotiert, nicht intrinsisch leitend ist sowie eine Leitfähigkeit unterhalb von 10⁻⁴ S/m besitzt, die aber unter der Wirkung eines elektrischen Felds ansteigen kann, wobei dieses zweite Polymer sich in der Matrix in einem Anteil von 5 bis 70 Gew.% befindet und wobei dieses Material eine Leitfähigkeit unterhalb 10⁻⁸ S/m besitzt, die unter der Wirkung des elektrischen Felds ansteigen kann, und daß das thermoplastische Polymer unter Acryl,-Styrol-, Vinyl- und Zelluloseharzen, den Polyolefinen, den fluorierten Polymeren, den Polyäthern, den Polyimiden, den Polykarbonaten, den Polyurethanen, ihren Mischungen und ihren Kopolymeren ausgewählt wird und das wärmehärtbare Polymer unter den Polyestern, den Epoxydharzen und den Phenolharzen ausgewählt wird.

2. Material für eine Halbleiter-Abschirmung nach Anspruch 1, dadurch gekennzeichnet, daß die Leitfähigkeit des zweiten konjugierten undotierten oder entdotierten Polymers zwischen 10⁻⁷ S/m und 10⁻⁸ S/m und die Leitfähigkeit des Materials zwischen 10⁻⁹ S/m und 10⁻¹⁰ S/m liegt.

3. Material für eine Halbleiter-Abschirmung nach Anspruch 1, dadurch gekennzeichnet, daß die Polymermatrix außerdem einen leitenden Füllstoff wie Kohlenstoffruß in einem Anteil von weniger als 30% aufweist.

4. Material für eine Halbleiter-Abschirmung nach Anspruch 1, dadurch gekennzeichnet, daß das thermoplastische Polymer aus Polypropylen, Polyäthylen, dem Kopolymer von Äthylen und Vinylacetat, dem Äthylenpropylendienmonomer, dem fluorierten Polyvinyliden, dem Äthylenbutylacrylat und ihren Mischungen ausgewählt wird.

5. Material für eine Halbleiter-Abschirmung nach einem der Ansprüche 1 bis 4, dadurch gekennzeichnet, daß das zweite konjugierte Polymer aus der Gruppe ausgewählt wird, die Polyanilin, Polythiophen, Polypyrrol, Polyacetylen, Polyparaphenylen, Polyalkylthiophene, ihre Derivate und ihre Mischungen enthält.

6. Material für eine Halbleiter-Abschirmung nach Anspruch 5, dadurch gekennzeichnet, daß das zweite konjugierte Polymer Polyanilin ist und daß die Polymermatrix mindestens ein Material aufweist, das aus Polyäthylen, Polypropylen, dem Kopolymer von Äthylen und Vinylacetat, Äthylenbutylacrylat, Äthylenpropylendienmonomer und fluoriertem Polyvinyliden alleine oder in Mischung ausgewählt wird.

7. Anwendung des Materials für eine Halbleiter-Abschirmung nach einem der vorhergehenden Ansprüche auf die Abschirmung von elektrischen Kabeln in Höhe der Enden, der Anschlüsse und der Ableitungen.

8. Anwendung des Materials für eine Halbleiter-Abschirmung nach einem der Ansprüche 1 bis 6 auf einen Kondensator, wobei die Abschirmung zwischen den Elektroden und dem Dielektrikum des Kondensators angeordnet ist.

9. Anwendung des Materials für eine Halbleiter-Abschirmung nach einem der Ansprüche 1 bis 6 auf ein Dielektrikum für eine Raumantenne.

## Claims

1. A material for semiconductive screening, said material including a polymer matrix comprising at least one thermoplastic or thermosetting insulating first polymer and in which matrix at least one conjugated second polymer is incorporated, said material being characterized by the fact that said conjugated second polymer is not doped or is dedoped, and is not intrinsically conductive, having conductivity which is less than 10⁻⁴ S/m, but which is capable of increasing under the effect of an electric field, the concentration of the second polymer in said matrix lying in the range 5% to 70% by weight, said material having conductivity which is less than 10⁻⁸ S/m, but which is capable of increasing under the effect of said electric field, said thermoplastic polymer being chosen from resins made of acrylic, styrene, vinyl, and cellulose, and from polyolefins, fluoride polymers, polyethers, polyimides, polycarbonates, polyurethanes, and mixtures and copolymers thereof, said thermosetting polymer being chosen from polyesters, epoxy resins, and phenol resins.

2. A material for semiconductive screening according to claim 1, characterized by the fact that said conductivity of said non-doped or dedoped conjugated second polymer lies approximately in the range 10⁻⁷ S/m to 10⁻⁸ S/m and said conductivity of said material lies approximately in the range 10⁻⁹ S/m to 10⁻¹⁰ S/m.

3. A material for semiconductive screening according to claim 1, characterized by the fact that said polymer matrix further contains a conductive filler of the carbon black type in a concentration of less than 30%.

4. A material for semiconductive screening according to claim 1, characterized by the fact that said thermoplastic polymer is chosen from polypropylene, polyethylene, the copolymer of ethylene and vinyl acetate, ethylene propylene terpolymer, polyvinylidene fluoride, ethylene butyl acrylate, and mixtures thereof.

5. A material for semiconductive screening according to any one of claims 1 to 4, characterized by the fact that said conjugated second polymer is chosen from the group comprising polyaniline, polythiophene, polypyrrol, polyacetylene, polyparaphenylene, polyalkylthiophenes, and derivatives and mixtures thereof.

6. A material for semiconductive screening according to claim 5, characterized by the facts that said conjugated second polymer is polyaniline, and that said polymer matrix comprises at least one material chosen from polyethylene, polypropylene, the copolymer of ethylene and vinyl acetate, ethylene butyl acrylate, ethylene propylene terpolymer, and polyvinylidene fluoride, on their own or mixed.

7. Use of the material for semiconductive screening according to any preceding claim in shielding electrical cables, at ends, splices, and branches.

8. Use of the material for semiconductive screening according to any one of claims 1 to 6, for a capacitor, said screening being disposed between the electrodes and the dielectric of said capacitor.

9. Use of the material for semiconductive screening according to any one of claims 1 to 6, for a dielectric for a space-array antenna.
